# EUROPÄISCHE PATENTANMELDUNG

(11) **EP 3 734 349 A1**
(43) Veröffentlichungstag der Anmeldung: **04.11.2020**
(21) Anmeldenummer: 20178906.2
(22) Anmeldetag: 20.12.2016
(51) Int. Cl.: G02B 26/08, G03F 7/20, G03F 7/213

(54) **VORRICHTUNG UND VERFAHREN ZUR BELICHTUNG EINER LICHTEMPFINDLICHEN SCHICHT**

(62) Teilanmeldung aus: 16819533.7
(71) Anmelder: EV Group E. Thallner GmbH, 4782 St. Florian am Inn (AT)
(72) Erfinder: THALLNER, Bernhard, 4782 St. Florian am Inn (AT); POVAZAY, Boris, 4782 St. Florian am Inn (AT)
(74) Vertreter: Schneider, Sascha

(57) **Zusammenfassung**

Die vorliegende Erfindung betrifft ein Verfahren zur Belichtung einer lichtempfindlichen Schicht (9) mit einem optischen System (8), wobei mindestens ein Lichtstrahl (6, 6') jeweils von mindestens einer Lichtquelle (7) erzeugt wird und Pixel (23) eines Belichtungsrasters (24, 24', 24", 24"') durch mindestens eine Mikrospiegeleinrichtung (1) mit einer Vielzahl von Mikrospiegeln (3) beleuchtet werden, dadurch gekennzeichnet, dass eine, insbesondere affine Verzerrung, insbesondere eine Scherung, des Belichtungsrasters (24, 24', 24", 24'") erfolgt.

## Beschreibung

Die vorliegende Erfindung betrifft ein Verfahren zur Belichtung einer lichtempfindlichen Schicht gemäß Anspruch 1 sowie eine korrespondierende Vorrichtung gemäß Anspruch 6.

Mikrospiegelvorrichtungen (engl.: Digital Micromirror Device, DMD) sind im Stand der Technik bereits seit langem bekannt. Es handelt sich dabei um optische Elemente, die aus einer Vielzahl kleiner Spiegel bestehen, die einzeln bewegt/ausgerichtet werden können. Jeder Spiegel kann gezielt elektrisch angesteuert und orientiert werden. Dadurch kann ein optisches System mit einem DMD dazu verwendet werden, um einen breiten Lichtstrahl selektiv ortsaufgelöst abzulenken. Meistens werden pro Spiegel nur zwei voll ausgelenkte Positionen betrachtet. Entweder ein Spiegel lässt den Teil des Lichtstrahls, der auf ihn fällt durch das optische System weiter passieren oder er reflektiert den Teil des Lichtstrahls so, dass das Licht im optischen System nicht weitergeführt wird. Man kann dann jeden Spiegel eines solchen DMDs als digitalen Lichtschalter interpretieren.

Derartige DMDs werden im Stand der Technik vor allem bereits in Projektoren eingesetzt. Zunehmend finden DMD auch Anwendung im industriellen Umfeld, wie z.B. beim 3D-Druck, der 3D-Vermessung und maskenlosen Lithographie.

Im Stand der Technik sind ausschließlich maskenlose Belichter bekannt, die über eine einzige Lichtquelle verfügen, welche das DMD und damit die zu belichtende Oberfläche bestrahlen.

Es ist daher die Aufgabe der vorliegenden Erfindung, die Nachteile des Stands der Technik zu beseitigen und insbesondere ein verbessertes Belichtungsergebnis zu erzielen.

Diese Aufgabe wird mit den Gegenständen der nebengeordneten Patentansprüche sowie den nachfolgend offenbarten Erfindungsgedanken gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Zeichnungen angegebenen Merkmalen. Bei Wertebereichen sollen auch innerhalb der genannten Grenzen liegende Werte als Grenzwerte offenbart und in beliebiger Kombination beanspruchbar sein.

Die Erfindung betrifft ein Verfahren zur Belichtung einer lichtempfindlichen Schicht mit einem optischen System, wobei mindestens ein Lichtstrahl jeweils von mindestens einer Lichtquelle erzeugt wird und Pixel eines Belichtungsrasters durch mindestens eine Mikrospiegeleinrichtung mit einer Vielzahl von Mikrospiegeln beleuchtet werden, wobei horizontale und/oder vertikale Belichtungsrastergitterlinien des Belichtungsrasters schräg verlaufend angeordnet und/oder verzerrt werden.

Die Erfindung betrifft weiterhin eine Vorrichtung zur Belichtung einer lichtempfindlichen Schicht mit einem optischen System mit:
- mindestens einer Lichtquelle zur Erzeugung mindestens eines Lichtstrahls,
- mindestens eine Mikrospiegeleinrichtung mit einer Vielzahl von Mikrospiegeln, wobei jeder Mikrospiegel zur Beleuchtung eines Pixels eines Belichtungsrasters dient,
wobei horizontale und/oder vertikale Belichtungsrastergitterlinien des Belichtungsrasters schräg verlaufend angeordnet sind und/oder verzerrt sind.

Bevorzugt ist vorgesehen, dass die horizontale und/odervertikale Belichtungsrastergitterlinien parallel zueinander verlaufend angeordnet sind oder ausgerichtet werden.

Bevorzugt ist weiterhin vorgesehen, dass die horizontale und/oder vertikale Belichtungsrastergitterlinien affin verzerrt werden.

Bevorzugt ist weiterhin vorgesehen, dass die Überlagerung durch unscharfe Abbildung der Mikrospiegel im Belichtungsraster erfolgt.

Bevorzugt ist weiterhin vorgesehen, dass das Belichtungsraster durch optische Elemente im Strahlengang schräg angeordnet und/oder verzerrt wird.

Die Erfindung zeigt insbesondere auf, wie ein verbesserter, schnellerer, höher aufgelöster Belichtungsvorgang durchgeführt werden kann.

Der Kerngedanke der Erfindung besteht darin mit Hilfe optischer Elemente eine Verzerrung des DMDs Bildes so durchzuführen, dass eine Erhöhung der Auflösung vom Raster der Intensitätsprofile, erfolgen kann.

Das Intensitätsprofil eines Pixels wird vorzugsweise so gewählt, dass 50% der Energie eines Pixels in der direkt entsprechenden Bildfläche zu finden sind und weitere 50% auf die benachbarten Felder aufgeteilt werden. In einer bevorzugteren erfindungsgemäßen Ausführungsform wird das Intensitätsprofil eines Pixels so gewählt, dass mehr als 50% der Energie eines Pixels in der direkt entsprechenden Bildfläche zu finden sind und die verbleibenden weniger als 50% auf die benachbarten Felder aufgeteilt werden. In einer anderen, weniger bevorzugten erfindungsgemäßen Ausführungsform wird das Intensitätsprofil eines Pixels so gewählt, dass weniger als 50% der Energie eines Pixels in der direkt entsprechenden Bildfläche zu finden sind und die verbleibenden mehr als 50% auf die benachbarten Felder aufgeteilt werden.

Die Erfindung beschreibt insbesondere eine maskenlose Belichtungsvorrichtung beziehungsweise ein maskenloses Belichtungsverfahren. Der Belichter wird in mehreren, miteinander kombinierbaren Ausführungsformen beschrieben. Insbesondere handelt es sich um unabhängige, aber miteinander kombinierbare Optimierungsmöglichkeiten.

Die wichtigste Ausführungsform besteht in der Auslegung des optischen Systems in der Art und Weise, dass es zu einer Verzerrung des DMD Bildes entlang des optischen Pfades kommt.

Vor allem werden Ausführungsformen offenbart, bei denen das optische System zwischen dem DMD und der zu belichtenden, lichtempfindlichen Schicht (zu belichtendes Material) eine orthogonal (insbesondere parallel zur Oberfläche der zu belichtenden Schicht) verzerrte Darstellung des Urbildes erzeugt. Durch die optische Verzerrung des Bildes kann insbesondere die Positioniergenauigkeit bzw. der Overlay erhöht werden. Unter der Positioniergenauigkeit zu einer bestehenden Struktur versteht man im speziellen Fall, dass durch die erfindungsgemäße verzerrte Darstellung des Urbildes die Auflösung der zu schreibenden Strukturen erhöht wird.

### Vorteile der Erfindung

Es werden keine Masken benötigt, so dass die gewünschte Struktur direkt in eine lichtempfindliche (photosensitive) Schicht belichtet werden kann. Durch die Verwendung mehrerer Lichtquellen kann das Spektrum breiter gewählt sowie die Lichtleistung und damit der erzielbare Durchsatz erhöht werden.

Erfindungsgemäß weist die Vorrichtung insbesondere ein optisches System mit folgenden Merkmalen auf:
- mindestens eine Lichtquelle zur Erzeugung mindestens eines Lichtstrahls,
- mindestens eine Mikrospiegeleinrichtung mit einer Vielzahl von Mikrospiegeln, wobei jeder Mikrospiegel zur Beleuchtung eines Pixels eines Belichtungsrasters mit einem Spiegelintensitätsprofil dient,
wobei das optische System derart ausgebildet ist, dass eine Verzerrung des DMD Bildes entlang des optischen Pfades erfolgt.

Bei der erfindungsgemäßen Verzerrung handelt es sich insbesondere um eine affine Transformation, noch bevorzugter um eine Scherung.

Die Erfindung beschreibt eine Methode und eine Anlage, um mit Hilfe eines Lichtstrahlenbündels, insbesondere eines Lasers, das durch ein optisches System, bestehend aus mindestens einer, vorzugsweise digitalen, Mikrospiegelvorrichtung (engl.: Digital Micromirror Device, DMD), geleitet wird, eine lichtempfindliche Schicht zu bestrahlen. Die Bestrahlung der Schicht führt zu einer physikalischen und/oder chemischen Veränderung der Schicht.

Die erfindungsgemäßen Ausführungsformen können insbesondere als
- vollflächige
- kontinuierlich abtastende (scannende)
- schrittweise (steppende)
maskenlose Belichter konzipiert werden. Als "maskenlos" wird der Ersatz der Abbildung einer statischen Vorlage (Maske, Reticle) durch ein dynamisch optisch musterndes System verstanden.

Unter einem vollflächigen, maskenlosen Belichter versteht man eine Anlage, welche über ein DMD verfügt, das den gesamten zu beschreibenden Bereich belichten kann, ohne nennenswerte relative Verschiebung zwischen der zu belichtenden Schicht und dem optischen System. Damit können nach heutigem Stand der Technik nur sehr kleiner Substrate belichtet werden, da die Größe heutiger DMDs begrenzt ist.

Unter einem abtastenden (scannenden), maskenlosen Belichter wird eine Vorrichtung beziehungsweise ein Verfahren verstanden, bei der/dem das Belichtungsfeld kleiner als der zu belichtende Bereich ist, sodass eine relative Verschiebung zwischen dem optischen System und der zu belichtenden Schicht erfolgt, um das gesamte Belichtungsfeld zu belichten. Diese relative Verschiebung erfolgt insbesondere kontinuierlich entlang eines Pfades. Der Pfad ist vorzugsweise:
- Mäanderförmig
- Zeilenförmig mit Verschiebung in die nächste Zeile und Rückstellung an den Anfang bei Erreichen des Endes,
- Spiralförmig,
- Kreisförmig,
- Linear.

Insbesondere können die genannten Pfade auch miteinander kombiniert werden. So ist es denkbar, zuerst einen spiralförmigen Pfad zur Belichtung zu verwenden, gefolgt von einem linearen Pfad, der insbesondere durch das Zentrum des Substrats führt oder mehrere anfangs unabhängige Schreibfade einander ergänzen. Bevorzugt wird mäanderförmig gefahren.

Unter einem steppenden maskenlosen Belichter versteht man eine Anlage, bei der das Belichtungsfeld kleiner als der zu belichtenden Bereich ist, die relative Verschiebung zwischen dem optischen System und der zu belichtenden Schicht schrittweise erfolgt und zwischen den einzelnen Schritten keine Belichtung erfolgt. Erst wenn optisches System und die zu belichtende Schicht sich in einer wohldefinierten Position befinden, belichtet das optische System die zu belichtende Schicht. Bei dieser Ausführungsform handelt es sich also um ein Belichten mehrerer Teilbereiche der zu belichtende Schicht.

### Das DMD Prinzip

Ein DMD erlaubt die gezielte Ablenkung, insbesondere mehrerer Teile, eines breiten primären, vorzugsweise parallelen und/oder nicht streuenden, Strahlenbündels. Dadurch kann, ohne Zuhilfenahme einer Maske, ein räumlich strukturiertes, sekundäres optisches Belichtungsstrahlenbündel erzeugt werden. Dem DMD sind meistens Optiken, insbesondere Projektionsoptiken, vor- und/oder nachgelagert, welche den auf das DMD fallenden primären Belichtungsstrahl und/oder die vom DMD reflektierten sekundären Belichtungsstrahlen manipulieren (insbesondere skalieren) können, und bei der Mikrolithographie insbesondere eine Verkleinerung des DMD Bildes erzeugen können. Dadurch kann das DMD-Bild entsprechend verkleinert werden.

Die dadurch erreichbare Strukturauflösung eines DMDs liegt insbesondere zwischen 0.1 µm und 50 µm, vorzugsweise zwischen 0.3 µm und 25 µm, noch bevorzugter zwischen 1 µm und 10 µm.

Vor allem für Ausführungsformen, bei denen das individuelle Belichtungsfeld kleiner als das Substrat ist, ist es von Bedeutung, dass nach einer Relativbewegung zwischen dem optischen System und der zu belichtenden Schicht eine nahtlose Weiterführung der zu erzeugenden Strukturen erfolgt. Beim Steppen erfolgt das in zwei unabhängigen Richtungen, beim kontinuierlichen Abtasten meist nur in einer.

### Das optische System

Die erfindungsgemäßen Ausführungsformen bestehen aus mindestens einem optischen System, welches mehrere optische Elemente unterschiedlicher Art beinhalten kann. Mindestens eines der optischen Elemente ist ein DMD, obwohl die Verwendung mehrerer DMDs eine weitere erfindungsgemäße Ausführungsform darstellt. Insbesondere befinden sich genau ein DMD, vorzugsweise mindestens zwei DMDs, noch bevorzugter mindestens vier DMDs im optischen System. Das optische System selbst kann in einer oder mehreren Formen parallel auf einem Substrat innerhalb einer Anlage zum Einsatz kommen. Auch das parallele Belichten mehrerer Substrate innerhalb der Anlage ist erfindungsgemäß denkbar.

Im optischen System können sich des Weiteren folgende optischen Elemente befinden:
- Beleuchtungsoptik
   ∘ Kohärente Lichtquellen, insbesondere
      ▪ Laserlichtquellen
      - Laserdioden
      - Festkörperlaser
      - Excimerlaser
   ∘ Inkohärente Lichtquellen, insbesondere
      ▪ Gasentladungslampen, insbesondere
         - Quecksilberdampflampen
      ▪ LED
   ∘ Teilkohärente Lichtquellen
   ∘ Kohärenzändernde Komponenten
- Ablenkungsoptik
   ∘ DMDs
   ∘ Spiegel, insbesondere
      ▪ Kaltspiegel
      ▪ Warmspiegel
   ∘ Refraktionselemente, insbesondere
      ▪ Prismen
      ▪ Strahlteiler
- Projektionsoptik
   ∘ Linsen, insbesondere
      ▪ Fresnellinsen
      ▪ Refraktionslinsen
         - Konvexlinsen
         - Konkavlinsen
         - Bikonkavlinsen
         - Bikonvexlinsen
         - Konvexkonkavlinsen
         - Konkavkonvexlinsen
         - Zylinderlinsen
         - Verbundlinsen
   ∘ Spiegel, insbesondere
      ▪ Zylinderspiegel
   ∘ Allgemeine strahlverändernde optische Komponenten
Die Lichtquellen können kontinuierlich oder gepulst verwendet, insbesondere zusätzlich intern oder extern moduliert, werden.

Die maximal mögliche Relativgeschwindigkeit zwischen dem optischen System und der zu belichtenden Schicht wird insbesondere durch die maximale Ansteuerungsfrequenz des DMDs (also der Frequenz, mit der die einzelnen Spiegelelemente eines DMD tatsächlich geschaltet werden können) beschränkt. Die Relativgeschwindigkeit in einem scannenden System ist des Weiteren durch die Verschiebe- und/oder Ablenkoptik bestimmt und liegt insbesondere zwischen 5 mm/s und 500 mm/s, vorzugsweise zwischen 10 mm/s und 250 mm/s, noch bevorzugter zwischen 15 mm/s und 200 mm/s am bevorzugtesten zwischen 25 mm/s und 100 mm/s.

Ein weiterer wichtiger Aspekt einer erfindungsgemäßen Ausführungsform besteht darin, eine höheren Vorschubgeschwindigkeit zu verwenden als durch die Rastergröße und Abtastfrequenz definiert ist. Durch die Wahl einer entsprechend höheren Vorschubgeschwindigkeit werden Zeilen ausgelassen, die durch, zeitlich gesehen, spätere Belichtungszeilen des DMD ergänzt werden.

### Integrierte Messoptik

Vorzugsweise weist die Vorrichtung eine, insbesondere im optischen System integrierte, Messoptik auf. Mit besonderem Vorzug wird ein Strahlteiler verwendet, um das von der zu belichtenden Schicht reflektierte Licht aus demselben optischen Pfad auszukoppeln, mit dem das DMD für die Belichtung beaufschlagt wird. Die Messoptik hat mehrere wichtige Aufgaben, die nicht alle gleichzeitig erfüllt sein müssen:
- Ausrichtung, um das Belichtungsfeld zu vorhandenen Strukturen am Substrat auszurichten oder neu zu formen,
- Kalibrierung und Überprüfung des Schreibkopfs,
- In-Situ Kontrolle des Schreibvorgangs,
- Echtzeitkorrektur bei dynamischen Veränderungen der relativen Bild-Substratlage.

Die Ausrichtung erfolgt entweder in Bezug zu bereits am Substrat aufgebrachten Ausrichtungsmarken oder, an bewusst aufgebrachten oder bereits vorhandenen Strukturen, die als Ausrichtungsmarken oder Passmarken (engl.: alignment marks) für die neu zu belichtenden Strukturen dienen. Dadurch wird es erfindungsgemäß möglich, große Flächen zu belichten, indem das optische System an den bereits belichteten Strukturen neu ausgerichtet und/oder kalibriert wird.

Ein weiterer wichtiger Aspekt einer erfindungsgemäßen Ausführungsform besteht darin, dass durch Vergleich der aktuell gemessenen Position der Passmarken mit den Sollpositionen eine etwaige, insbesondere durch Vorprozesse und/oder thermische Einflüsse bewirkte, Verzerrung des Substrats berechnet wird und das zu schreibende Abbild an diese Verzerrung angepasst wird. Die können auch Verzerrungen höherer Ordnung sein.

Speziell bei der Vermeidung von Vernähungsartefakten (Fehler an Übergängen zwischen benachbarten Pixeln und/oder benachbarten Belichtungsrastern) spielt die Ausrichtung und/oder Echtzeitkorrektur eine wichtige Rolle.

Durch Erfassung der Strukturen (können auch oberflächentypisches Rauschen sein) des Belichtungsfeldes bei der Belichtung und einem Abgleich mit einer Erfassung benachbarter Belichtungsstrukturen kann über Korrelation oder ähnliche Verfahren ein Versatz des Substrates festgestellt werden. Dieser wird als Fehlersignal dem DMD-Bild beaufschlagt, womit eine Kompensation bis in den Subpixelbereich hin möglich ist.

Die Erfassung/Vermessung erfolgt vorzugsweise entlang desselben optischen Pfades, der auch zum Belichten verwendet wird, damit eine mechanische Verbindung, insbesondere Fixierung, während der Erfassung/Vermessung realisiert werden kann.

Zur Erfassung/Vermessung wird das Lichtsignal (Lichtstrahl der mindestens einen Lichtquelle) von der Oberfläche über ein optisches Element, vorzugsweise einen halbdurchlässigen Spiegel oder ein Prisma, ausgekoppelt und von einem entsprechenden Detektor aufgenommen. Der Detektor (oder ein daran angeschlossenes Auswertungssystem) ist dann in der Lage, die Oberfläche der zu strukturierenden Schicht zu überwachen, während sie belichtet/beschrieben wird. Bei dem Detektor handelt es sich vorzugsweise um eine Kamera, noch bevorzugter um eine CCD- oder CMOS-Kamera. Das Kamerabild kann ein oder mehrere Teile, einen größeren Bereich oder einen oder mehrere kleiner Teilbereiche des Bestrahlungsfeldes erfassen. Die Belichtung kann über eine eigene Lichtquelle verfügen und im gleichen (bevorzugt) oder in einem anderen Wellenlängenbereich der Bestrahlung erfolgen.

In einer besonderen erweiterten Ausführungsform existiert auch eine Vermessungsoptik auf der Unterseite der erfindungsgemäßen Ausführungsform, mit deren Hilfe man Ausrichtungsmarken an der Unterseite des Substrathalters oder des Substrates detektieren kann. Das Prinzip der Unterseitenvermessung eines Substrathalters ist ähnlich der Ausführungsform, welche in der Druckschrift PCT/EP2016/070289 offenbart wird. Die Vermessung von Ausrichtungsmarken an der Unterseite ermöglicht es, Strukturen auf beiden Seiten zu erstellen die zueinander ausgerichtet sind.

Die Leistung der Lichtquelle liegt insbesondere zwischen 0.01 Watt und 1000 Watt, vorzugsweise zwischen 0.1 Watt und 500 Watt, noch bevorzugter zwischen 1 Watt und 250 Watt, am bevorzugtesten zwischen 5 Watt und 100 Watt, am allerbevorzugtesten zwischen 9 und 13 Watt.

Die Intensität wird in W/m² angegeben. Durch die Bündelung der Strahlung mittels optischer Elemente auf eine Einheitsfläche kann die Intensität entsprechend einfach kalkuliert werden. Die Intensität der Lichtquelle kann vorzugsweise sehr genau geregelt werden. Die Intensität wird entweder durch die Veränderung der Leistung der Lichtquelle, durch die Dauer der Belichtung oder durch optische Elemente im optischen System verändert. Dadurch wird es erfindungsgemäß möglich, Lichtstrahlen unterschiedlicher Intensität innerhalb eines wohldefinierten Zeitraums auf das DMD einzustrahlen. Durch eine entsprechende Spiegelsteuerung können so einzelne Punkte der zu belichtenden Schicht mit definierten Intensitäten bestrahlt werden. Die umliegenden Punkte der zu belichtenden Schicht können mit einer davon unterschiedlichen Intensität beleuchtet werden.

### Anisotrop und oder verzerrte Abbildungsoptik zur Verbesserung des Overlay-Fehlers und/oder der Bewegungsunschärfe

In einer erfindungsgemäßen Ausführungsform werden horizontale und/oder vertikale Belichtungsrastergitterlinien des Belichtungsrasters durch die optische Abbildung unterschiedlich abgebildet (also insbesondere nicht quadratisch), sodass eine unterschiedliche Belichtungsrasterauflösung in vertikaler und horizontaler Richtung eingestellt wird. Die Berechnung/Steuerung der Belichtung wird um die Abweichung kompensiert.

In einer weiteren Ausführungsform werden die Achsen der Abbildung beziehungsweise die Belichtungsrastergitterlinien nicht orthogonal, also schräg verlaufend angeordnet. Der Einsatz einer solchen, insbesondere affin verzerrten, Projektion (insbesondere einer Scherung) ermöglicht eine einfache Berechnung der Bestrahlungspositionen und eine lineare Führung unter präziser Platzierung der Beleuchtungspunkte unterhalb der Rasterauflösung (Subpixelgenauigkeit) zur hochgenauen Formung der Belichtungskanten.

In weiteren erfindungsgemäßen Ausführungsformen werden die horizontalen und/oder die vertikalen Belichtungsrastergitterlinien des Belichtungsrasters entlang der vertikalen und/oder horizontalen Richtung nicht äquidistant ausgeführt.

Die unterschiedlichen Belichtungsraster können durch die dem DMD vor- und/oder nachgeschalteten optischen Elemente aus einem homogen isotropen Bild des DMDs erzeugt werden und/oder sind ein direktes Resultat eines anisotrop und/oder inhomogen konstruierten DMDs.

Im weiteren Verlauf werden einige Möglichkeiten aufgezeigt, um eine entsprechende erfindungsgemäße Projektion, insbesondere Scherung des Belichtungsrasters zu erzeugen.

In einer ersten erfindungsgemäßen möglichen Ausführungsform wird mindestens eine Zylinderlinse mit einer Zylinderachse als Abbildungsoptik verwendet. Insbesondere werden genau zwei Zylinderlinsen verwendet. Die Zylinderachsen der Zylinderlinsen liegen vorzugsweise parallel zur zu belichtenden Oberfläche. Um eine erfindungsgemäße Scherung zu erzielen, wird zwischen den beiden Zylinderachsen ein Winkel kleiner als 90°, vorzugsweise kleiner als 70°, noch bevorzugter kleiner als 50°, am bevorzugtesten kleiner als 20° eingestellt. Der allerbevorzugteste Winkel ergibt sich allerdings aus dem zu erzeugenden Scherwinkel.

In einer weiteren erfindungsgemäßen Ausführungsform besteht das optische System aus nur einer einzigen sogenannten Verbundlinse. Unter einer Verbundlinse versteht man eine Linse, deren Oberflächen so geschliffen wurden, dass die optischen Eigenschaften identisch zu jenen optischen Eigenschaften sind, die man durch Kombination zweier Linsen erhalten würde.

Die oben angegebenen Ausführungsformen lassen sich sowohl mit einem regelmäßigen, aber auch unregelmäßigen Bestrahlen des Substrates erreichen. Im Spezialfall einer regelmäßigen, aber nicht exakt ganzzahlig zu der Verfahrgeschwindigkeit passenden Wiederholrate der Belichtung werden die Belichtungsstrukturen weiterhin exakt zur aktuellen Schreibposition aktiviert. Entsprechend ergeben sich nichtganzzahlige Versätze zu Subpixel-Platzierungen in Verfahrrichtung, die in einer verbesserten Platzierungsgenauigkeit und auch Kantenrauheit resultieren.

Eine Kombination der oben beschriebenen geometrischen und/oder zeitlichen Verschiebungen erzeugt eine Sub-Pixel-Auflösung in allen Richtungen und verringert die Fehleranfälligkeit gegenüber Ausfällen einzelner Belichtungskomponenten. Um die korrekte Belichtungsdosisverteilung zu charakterisieren, ist die Kenntnis von durch Abbildungsfehler und/oder künstlich hervorgerufenen Verzerrungen erforderlich. Linear verzerrte oder verdrehte Abbildungen haben den Vorteil einfacherer Berechnung sowie einer einfacheren Lichtquellensteuerung.

Alle genannten erfindungsgemäßen Ausführungsformen und Prozesse können beliebig miteinander kombiniert werden, werden aber einzeln beschrieben. Soweit Verfahrensmerkmale beschrieben sind, sollen diese auch als Vorrichtungsmerkmale offenbart gelten und umgekehrt.

Weitere Vorteile, Merkmale und Einzelheiten der Erfindung ergeben sich aus der nachfolgenden Beschreibung bevorzugter Ausführungsbeispiele sowie anhand der Zeichnungen. Die zeigen in:
- Figur 1: eine erste Ausführungsform der erfindungsgemäßen Vorrichtung,
- Figur 2: eine zweite Ausführungsform der erfindungsgemäßen Vorrichtung,
- Figur 3: eine dritte Ausführungsform der erfindungsgemäßen Vorrichtung,
- Figur 4a: eine schematische, nicht maßstabsgetreue Darstellung eines DMD (Mikrospiegeleinrichtung) mit einem vergrößerten Teilabschnitt mit Mikrospiegeln in einer ersten Position,
- Figur 4b: eine schematische, nicht maßstabsgetreue Darstellung eines DMD (Mikrospiegeleinrichtung) mit einem vergrößerten Teilabschnitt mit Mikrospiegeln in einer zweiten Position,
- Figur 5a: schematische, nicht maßstabsgetreue, vergrößerte Ansicht einer ersten Ausführungsform eines erfindungsgemäßen Belichtungsrasters,
- Figur 5b: schematische, nicht maßstabsgetreue, vergrößerte Ansicht einer ersten Ausführungsform eines erfindungsgemäßen Belichtungsrasters,
- Figur 6: eine schematische Ansicht eines durch optische Elemente verzerrten Belichtungsrasters.

In den Figuren sind gleiche Bauteile oder Bauteile mit der gleichen Funktion mit den gleichen Bezugszeichen gekennzeichnet.

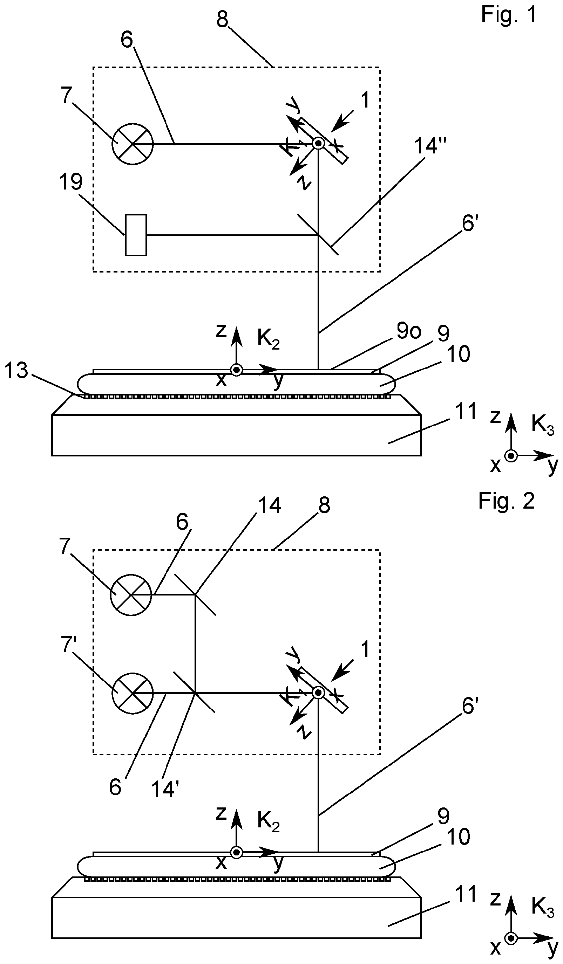

**Figur 1** zeigt eine erste Ausführungsform, bestehend aus einem optischen System 8, mit mindestens einer Lichtquelle 7 und mindestens einem DMD 1 (Mikrospiegeleinrichtung), einem Substrathalter 11. Der Substrathalter 11 kann in Bezug zu einem Koordinatensystem K3 bewegt werden.

Auf dem Substrathalter 11 wird mit Fixiermitteln 13 ein Substrat 10 fixiert, auf dem sich eine lichtempfindliche Schicht 9 aus einem belichtbaren Material befindet, die mittels der Vorrichtung belichtet wird.

Der Koordinatenursprung eines probenfesten (also auf das Substrat 10 beziehungsweise die zu belichtende Schicht 9 fixe) Koordinatensystems K2 wird vorzugsweise ins Zentrum der Oberfläche 9o der Schicht 9 gelegt.

Ein Lichtstrahl 6 (primärer Lichtstrahl), der von der Lichtquelle 7 emittiert wird, und auf dem Weg zum DMD 1 mehrere optische Elemente (nicht eingezeichnet) passieren kann, wird vom DMD 1 in einen strukturierten Lichtstrahl 6' (sekundärer Lichtstrahl) umgewandelt. Dieser kann auf dem Weg zur Schicht 9 mehrere optische Elemente (nicht eingezeichnet, außer 14") passieren.

Mittels eines halbdurchlässigen Spiegels 14" kann ein Detektor 19, insbesondere eine Kamera, noch bevorzugter eine CCD- oder CMOS-Kamera, die Oberfläche 9o der zu belichtenden Schicht 9 direkt erfassen und/oder vermessen. Die Messergebnisse werden vorzugsweise zur unmittelbaren Steuerung des Verfahrens und/oder Kalibrierung der Vorrichtung eingesetzt. Auf die Darstellung derartiger Messmittel wird in den weiteren Figurenbeschreibungen und Figuren der Übersichtlichkeit halber verzichtet. Die erfindungsgemäßen Messmittel können aber in jeder genannten erfindungsgemäßen Ausführungsform verwendet werden.

**Figur 2** zeigt eine zweite Ausführungsform, wobei das optische System 8 hier mit zwei Lichtquellen 7, 7' ausgestattet ist. Lichtstrahlen 6 werden von den beiden Lichtquellen 7, 7' emittiert. Einer der Lichtstrahlen 6 wird durch einen Spiegel 14 auf einen Strahlteiler 14' umgeleitet und durch diesen mit dem Lichtstrahl 6 der zweiten Lichtquelle 7' vereint.

Der vereinte Lichtstrahl 6 wird auf das DMD 1 geleitet und von diesem in einen strukturierten Lichtstrahl 6' umgewandelt, der wiederum auf dem Weg zur Schicht 9 mehrere optische Elemente (nicht eingezeichnet) passieren kann.

Ein, insbesondere eigenständiger, erfindungsgemäßer Aspekt besteht hierbei vor allem darin, dass die beiden Lichtquellen 7 sich in Strahlungsintensität, Wellenlänge, Kohärenzlänge und gegebenenfalls weiteren Eigenschaften oder Parametern unterscheiden können, sodass ein Laserstrahl 6 mit einer Vielzahl unterschiedlicher optischer Parameter erzeugt werden kann.

Erfindungsgemäß können insbesondere mehr als 2, insbesondere mehr als 5, noch bevorzugter mehr als 10, am allerbevorzugtesten mehr als 20 Lichtquellen 7, 7' verwendet werden. Bei jeder Lichtquelle kann es sich vorzugsweise auch um ein LED-Feld oder LD (engl.: laser diode)-Feld handeln.

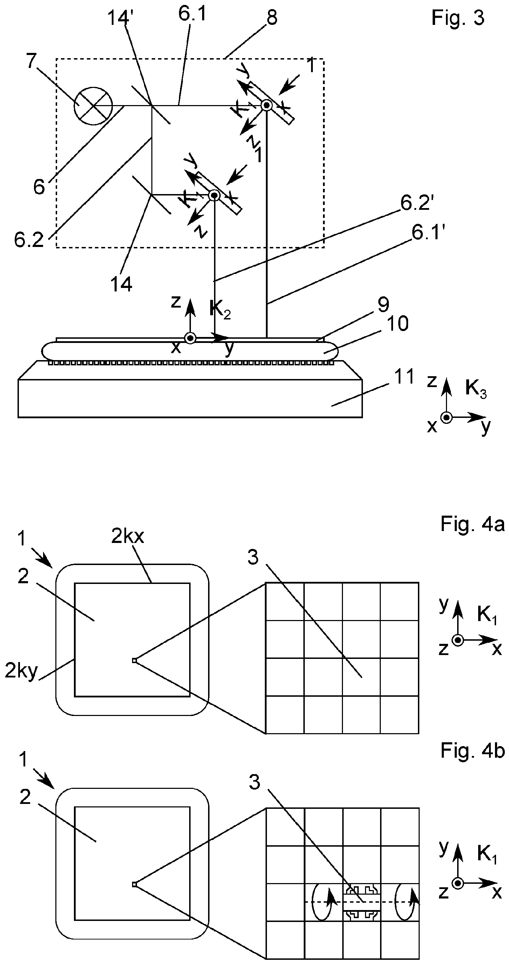

**Figur 3** zeigt eine dritte Ausführungsform, bestehend aus einem optischen System 8 mit mindestens einer Lichtquelle 7 und zwei DMDs 1.

Ein Lichtstrahl 6 wird von der Lichtquelle 7 emittiert und durch einen Strahlteiler 14' geteilt. Ein erster geteilter Lichtstrahl 6.1 wird von einem ersten DMD 1 zu einem ersten modifizierten Strahl 6.1' modifiziert. Mit dem ersten modifizierten Strahl 6.1' wird die Schicht 9 belichtet. Der zweite geteilte Lichtstrahl 6.2 wird mittels eines Spiegels 14 auf ein zweites DMD 1 umgeleitet und als zweiter modifizierter Strahl 6.2' auf die Schicht 9 weitergeleitet. Vorzugsweise wird mit dem zweiten modifizierten Strahl 6.2' eine andere Position der zu belichtenden Schicht 9 belichtet als mit dem ersten modifizierten Lichtstrahl 6.1'. Alle genannten Lichtstrahlen können dabei mehrere optische Elemente (nicht eingezeichnet) passieren.

Ein, insbesondere eigenständiger, erfindungsgemäßer Aspekt besteht hierbei darin, dass mindestens zwei DMDs 1 verwendet werden, mittels derer gleichzeitig an zwei verschiedenen Positionen der Schicht 9 belichtet werden kann, wobei vorzugsweise ein einziger, insbesondere vereinter, Lichtstrahl für die Beaufschlagung der DMDs verwendet wird. Dies führt insbesondere zu einer Verbreiterung des Belichtungsabschnitts, insbesondere Belichtungsstreifens, und damit in einer Erhöhung des Durchsatzes.

**Figur 4a** zeigt das DMD 1 mit einer Spiegelfläche 2. Die vergrößerte Darstellung eines Teils der Spiegelfläche 2 zeigt mehrere (16) Spiegel 3 einer Vielzahl von Spiegeln 3. Die Spiegel sind in einer nicht gekippten, als Ausgangsposition bezeichneten, Ausrichtung angeordnet. Dem DMD 1 wird ein Koordinatensystem K1 zugeordnet. Die Z-Achse von K1 (also K1z) steht normal auf die Spiegelfläche 2, die x- und die y-Koordinate liegen parallel zu den Spiegelflächenkanten 2kx und 2ky der Spiegelfläche 2 und definieren eine Spiegelebene.

**Figur 4b** zeigt dasselbe DMD 1, wobei einer der Spiegel 3 in einer um die x-Achse gekippten oder gedrehten Position angeordnet ist. Der Teil des Lichtstrahls 6, der auf den gekippten Spiegel 3 trifft, wird daher in einer Richtung reflektiert, die nicht identisch ist zu der Reflexionsrichtung von den nicht gekippten Spiegeln 3 reflektierten Teile des Lichtstrahls 6.

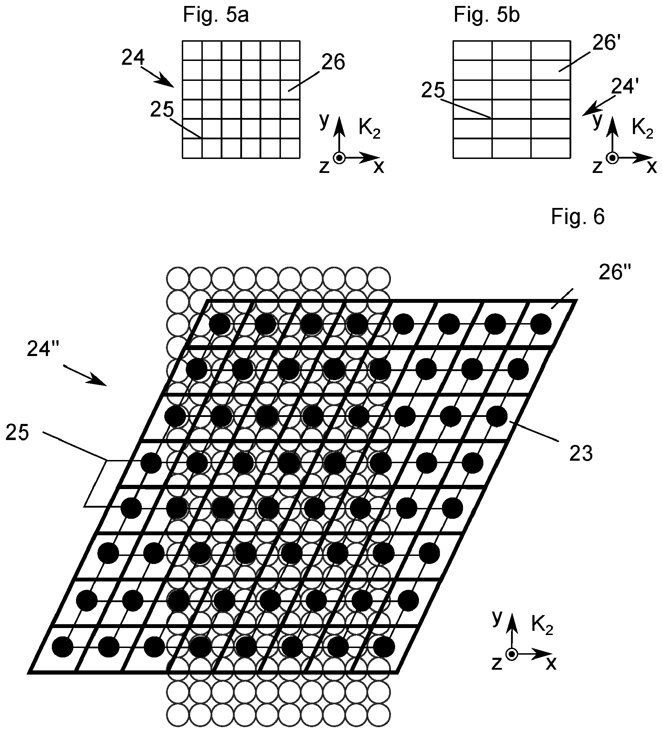

Die **Figur 5a** zeigt ein erstes, erfindungsgemäß weniger bevorzugtes Belichtungsraster 24, das in die beiden, zueinander orthogonalen Richtungen K2x, K2y äquidistante Abstände der Belichtungsrastergitterlinien 27 besitzt. Das Belichtungsraster 24 ist damit isotrop und homogen in beide Richtungen K2x und K2y.

Die **Figur 5b** zeigt ein zweites, erfindungsgemäß bevorzugteres Belichtungsraster 24', das für jede Richtung einen eigenen, insbesondere bezogen auf die Richtung äquidistanten, Abstand zwischen den Belichtungsrastergitterlinien 27 besitzt. Das Belichtungsraster 24' ist damit anisotrop, aber homogen in jeder der Richtungen K2x und K2y.

Denkbar ist auch, dass die Belichtung an Belichtungsrastergitterlinienschnittpunkten 25 und/oder Belichtungsrasterteilflächen 26 und nicht innerhalb der einzelnen Rasterflächen erfolgt.

Die unterschiedlichen Belichtungsraster 24, 24', 24", 24"'. können insbesondere durch dem DMD 1 (nicht eingezeichnet) vor- und/oder nachgelagerte optische Elemente (nicht eingezeichnet) erzeugt/modifiziert werden. Das DMD 1 (nicht eingezeichnet) wäre vorzugsweise isotrop und homogen, wobei die, insbesondere nur die nachgeschalteten, optischen Elemente (nicht eingezeichnet), eine anisotrope und/oder nicht homogene Abbildung des DMDs bewirkend ausgebildet sind.

Die **Figur 6** zeigt eine schematische, nicht maßstabsgetreue Aufsicht eines, insbesondere durch optische Elemente des optischen Systems 8, verzerrten Belichtungsrasters 24". Durch die optischen Elemente werden die von den Spiegeln 3 des DMDs 1 reflektierten Teilstrahlen orthogonal auf die zu belichtende Schicht 9 reflektiert, allerdings erfolgt, vorzugsweise ausschließlich, eine Verzerrung innerhalb der K2x-K2y Ebene. Durch dieses erfindungsgemäße Verfahren kann ein Belichtungsraster 24" optisch geschaffen werden, das zu einer erfindungsgemäßen Erhöhung des Overlays führt. Das DMD 1 wird bei dieser Ausführungsform vorzugsweise nicht schräg gestellt, sondern das Urbild des DMD 1 wird affin verzerrt, um die Schrägstellung des Belichtungsrasters 24" zu bewirken.

### Bezugszeichenliste

- 1: DMD
- 2: Spiegelfläche
- 2kx, 2ky: Spiegelflächenkanten
- 3,3': Spiegel
- 4: Schreibbereich
- 5: Pufferbereich
- 6: Lichtstrahl
- 6': modifizierter/strukturierter Lichtstrahl
- 6.1': erster modifizierter Strahl
- 6.2': zweiter modifizierter Strahl
- 7, 7': Lichtquellen
- 8: Optisches System
- 9: Schicht
- 10: Substrat
- 11: Substrathalter
- 12, 12', 12": Strukturen
- 13: Fixiermittel
- 14: Spiegel
- 14': Strahlteiler
- 14": halbdurchlässiger Spiegel
- 15, 15',15": Streifen
- 16l, 16r,16l', 16r',16r": Intensitätsvariationsbereich
- 17: Fokusebene
- 18: Tiefenschärfe
- 19: Detektor
- 20: Punktraster
- 22, 22', 22": Spiegelintensitätsprofile
- 23, 23': Pixel
- 24, 24', 24", 24"': Belichtungsraster
- 25: Belichtungsrastergitterlinienschnittpunkt
- 26: Belichtungsrasterteilfläche
- 27: Belichtungsrastergitterlinie
- 28: Muster
- l, l': Länge
- b: Breite
- D: Verfahrrichtung
- v: Vertikaler Punktrasterabstand
- h: Horizontaler Punktrasterabstand
- r: Belichtungspunktradius
- p: Spiegelzentrumsabstand

## Patentansprüche

1. Verfahren zur Belichtung einer lichtempfindlichen Schicht (9) mit einem optischen System (8), wobei mindestens ein Lichtstrahl (6, 6') jeweils von mindestens einer Lichtquelle (7) erzeugt wird und Pixel (23) eines Belichtungsrasters (24, 24', 24", 24''') durch mindestens eine Mikrospiegeleinrichtung (1) mit einer Vielzahl von Mikrospiegeln (3) beleuchtet werden, **dadurch gekennzeichnet, dass** horizontale und/oder vertikale Belichtungsrastergitterlinien des Belichtungsrasters (24, 24', 24", 24'") schräg verlaufend angeordnet und/oder verzerrt werden, wobei ein Intensitätsprofil eines Pixels (23) derart gewählt wird, dass mehr als 50% der Energie des Pixels (23) in der direkt entsprechenden Bildfläche zu finden sind und die verbleibenden weniger als 50% auf benachbarte Felder aufgeteilt werden.

2. Verfahren nach Anspruch 1, wobei die horizontale und/odervertikale Belichtungsrastergitterlinien parallel zueinander verlaufend angeordnet sind oder ausgerichtet werden.

3. Verfahren nach einem der vorhergehenden Ansprüche, wobei die horizontale und/oder vertikale Belichtungsrastergitterlinien affin verzerrt werden.

4. Verfahren nach einem der vorhergehenden Ansprüche, wobei die Überlagerung durch unscharfe Abbildung der Mikrospiegel (3) im Belichtungsraster (24, 24', 24", 24''') erfolgt.

5. Verfahren nach einem der vorhergehenden Ansprüche, wobei das Belichtungsraster (24, 24', 24", 24'") durch optische Elemente im Strahlengang schräg angeordnet und/oder verzerrt wird.

6. Vorrichtung zur Belichtung einer lichtempfindlichen Schicht (9) mit einem optischen System (8) mit:
- mindestens einer Lichtquelle (7) zur Erzeugung mindestens eines Lichtstrahls (6, 6'),
- mindestens eine Mikrospiegeleinrichtung (1) mit einer Vielzahl von Mikrospiegeln (3), wobei jeder Mikrospiegel (3) zur Beleuchtung eines Pixels (23) eines Belichtungsrasters (24, 24', 24", 24"') dient,
**dadurch gekennzeichnet, dass** horizontale und/oder vertikale Belichtungsrastergitterlinien des Belichtungsrasters (24, 24', 24", 24"') schräg verlaufend angeordnet sind und/oder verzerrt sind, wobei ein Intensitätsprofil eines Pixels (23) derart gewählt wird, dass mehr als 50% der Energie des Pixels (23) in der direkt entsprechenden Bildfläche zu finden sind und die verbleibenden weniger als 50% auf benachbarte Felder aufgeteilt werden.
